# EUROPÄISCHE PATENTANMELDUNG

(11) **EP 3 799 546 A1**
(43) Veröffentlichungstag der Anmeldung: **31.03.2021**
(21) Anmeldenummer: 19199594.3
(22) Anmeldetag: 25.09.2019
(51) Int. Cl.: H05K 5/06, H05K 7/20

(54) **TRÄGER FÜR ELEKTRISCHE BAUELEMENTE**

(71) Anmelder: Siemens Aktiengesellschaft, 80333 München (DE)
(72) Erfinder: Kappauf, Daniel, 91322 Gräfenberg (DE); Namyslo, Lutz, 91353 Hausen (DE)

(57) **Zusammenfassung**

Die Erfindung betrifft einen Träger (3) für wenigstens ein elektrisches Bauelement (5 bis 7). Der Träger (3) umfasst einen Kühlkörper (11) mit einer Kühlkörperoberfläche (31) und zwei von der Kühlkörperoberfläche (31) abstehenden, sich gegenüberliegenden Seitenwänden (25), zwei auf der Kühlkörperoberfläche (31) aufliegende, voneinander beabstandete Abdichtblöcke (13), die sich jeweils zwischen den beiden Seitenwänden (25) erstrecken und an jeder der beiden Seitenwände (25) anliegen, und eine auf der Kühlkörperoberfläche (31) zwischen den beiden Abdichtblöcken (13) angeordnete Trägerstruktur (15) für das wenigstens eine elektrische Bauelement (5 bis 7).

## Beschreibung

Die Erfindung betrifft einen Träger für wenigstens ein elektrisches Bauelement, ein Verfahren zur Herstellung eines derartigen Trägers sowie ein Elektronikmodul.

Die Fertigung von Elektronikmodulen mit Leistungshalbleitern wie IGBT (Bipolartransistoren mit isolierter Gate-Elektrode, engl. insulated-gate bipolar transistors) oder MOSFET (Metall-Oxid-Halbleiter-Feldeffekttransistoren, engl. metaloxide-semiconductor field-effect transistors) ist aufwändig und kostspielig. Um die hohen Isolationsanforderungen bei solchen Elektronikmodulen zu erfüllen, werden die Halbleiterchips und Bonddrähte mit einer Vergussmasse, beispielsweise einer silikonbasierten Weichvergussmasse, bedeckt. Die Vergussmasse verhindert zusätzlich das Eindringen von Feuchtigkeit und eine Korrosion der Bauteile. Während des Vergießens ist die Vergussmasse sehr dünnflüssig. Um eine gute Benetzung zu erreichen und Blasenbildung zu vermeiden wird der Verguss mit einem geringen Unterdruck durchgeführt. Ein Ausfließen der Vergussmasse während des Vergussprozesses und der Aushärtephase wird durch ein Modulgehäuse verhindert. Das Modulgehäuse muss dafür eine hohe Dichtigkeit in sich und zu einer Bodenplatte des Elektronikmoduls aufweisen. Deshalb werden die Modulgehäuseteile miteinander und mit der Bodenplatte durch einen hochelastischen Kleber verbunden. Der Klebeprozess und der Weichverguss erfordern mehrere Aufheizvorgänge zum Vortrocknen und Aushärten des Klebers und der Vergussmasse, welche hohe Fertigungsprozesszeiten verursachen. Ferner erfordert die Entwicklung eines Modulgehäuses einen relativ hohen Entwicklungsaufwand. Zusätzlich entstehen hohe Investitionskosten für Spritzgusswerkzeuge und eine Maschine zur automatischen Pin-Bestückung der Elektronikmodule. Auch die Werkzeugentwicklung für die Herstellung der Bodenplatte erfordert mehrere Iterationsschleifen.

Der Erfindung liegt die Aufgabe zugrunde, die Fertigung von Elektronikmodulen, insbesondere von Elektronikmodulen mit Leistungshalbleitern, zu vereinfachen und deren Kosten zu reduzieren.

Die Aufgabe wird erfindungsgemäß durch einen Träger für wenigstens ein elektrisches Bauelement mit den Merkmalen des Anspruchs 1, ein Verfahren zum Herstellen eines derartigen Trägers mit den Merkmalen des Anspruchs 12 und ein Elektronikmodul mit den Merkmalen des Anspruchs 13 gelöst.

Vorteilhafte Ausgestaltungen der Erfindung sind Gegenstand der Unteransprüche.

Ein erfindungsgemäßer Träger für wenigstens ein elektrisches Bauelement umfasst einen Kühlkörper mit einer Kühlkörperoberfläche und zwei von der Kühlkörperoberfläche abstehenden, sich gegenüberliegenden Seitenwänden, zwei auf der Kühlkörperoberfläche aufliegende, voneinander beabstandete Abdichtblöcke, die sich jeweils zwischen den beiden Seitenwänden erstrecken und an jeder der beiden Seitenwände anliegen, und eine auf der Kühlkörperoberfläche zwischen den beiden Abdichtblöcken angeordnete Trägerstruktur für das wenigstens eine elektrische Bauelement.

Ein erfindungsgemäßer Träger dient dazu, die Komplexität von Elektronikmodulen zu reduzieren, indem Funktionen von Bauteilen herkömmlicher Elektronikmodule von dem Träger übernommen werden und dadurch Bauteile eingespart oder vereinfacht werden. Dadurch wird die Fertigung eines Elektronikmoduls vereinfacht und Kosten der Fertigung werden reduziert. Insbesondere ermöglicht die Erfindung die Fertigung eines Elektronikmoduls mit Leistungshalbleitern ohne ein komplexes Modulgehäuse, das ein Ausfließen von Vergussmasse zur Isolierung der Leistungshalbleiter verhindert. Die Funktion des Modulgehäuses wird von den Seitenwänden und den Abdichtblöcken des erfindungsgemäßen Trägers übernommen, die ein Ausfließen von Vergussmasse vor deren Aushärtung verhindern. Insbesondere entfällt dadurch das Abdichten eines Modulgehäuses durch einen aufwändigen und langwierigen Klebeprozess mit einem auf die verwendeten Materialien abgestimmten Kleber. Ferner ist keine Bodenplatte für das Elektronikmodul mehr erforderlich, da deren Funktion von dem Kühlkörper übernommen wird. Die direkt auf der Kühlkörperoberfläche angeordnete Trägerstruktur ermöglicht eine verbesserte Entwärmung auf der Trägerstruktur angeordneter elektrischer Bauelemente und ermöglicht dadurch eine höhere Belastbarkeit der elektrischen Bauelemente und/oder eine verlängerte Lebensdauer der elektrischen Bauelemente.

Bei einer Ausgestaltung der Erfindung weist der Kühlkörper einen Grundkörper und eine die Kühlkörperoberfläche ausbildende Wärmespreizschicht, beispielsweise eine Kupferschicht, auf. Durch die zwischen dem Grundkörper und der Trägerstruktur angeordnete Wärmespreizschicht wird die Entwärmung auf der Trägerstruktur angeordneter elektrischer Bauelemente weiter verbessert.

Bei einer weiteren Ausgestaltung der Erfindung ist der Grundkörper aus Aluminium gefertigt. Aluminim eignet sich aufgrund seiner hohen Wärmeleitfähigkeit und relativ geringen Kosten als Material des Grundkörpers.

Bei einer weiteren Ausgestaltung der Erfindung ist jeder Abdichtblock durch wenigstens eine Schraubverbindung mit dem Kühlkörper kraftschlüssig verbindbar. Dies ermöglicht eine einfache Montage und eine flexible Positionierbarkeit der Abdichtblöcke.

Bei einer weiteren Ausgestaltung der Erfindung ist jeder Abdichtblock mit dem Kühlkörper durch wenigstens eine Nut-Feder-Verbindung formschlüssig verbunden. Durch Nut-FederVerbindungen kann die ein Ausfließen von Vergussemasse verhindernde Abdichtfunktion der Abdichtblöcke vorteilhaft verbessert werden.

Bei einer weiteren Ausgestaltung der Erfindung ist an wenigstens einem Abdichtblock wenigstens eine elektrisch leitfähige Anschlusslasche für einen elektrischen Leistungsanschluss angeordnet. Dadurch kann ein Abdichtblock neben seiner Abdichtfunkion auch eine Tragfunktion für wenigstens einen elektrischen Leistungsanschluss zur Versorgung der elektrischen Bauelemente mit Gleich- oder Wechselstrom erfüllen.

Bei einer weiteren Ausgestaltung der Erfindung sind die Abdichtblöcke aus Kunststoff gefertigt. Dies ermöglicht vorteilhaft eine einfache und kostengünstige Herstellung der Abdichtblöcke, beispielsweise durch Spritzgießen mit einem einfachen Spritzgießwerkzeug.

Bei einer weiteren Ausgestaltung der Erfindung weist die Trägerstruktur ein abseitig der Kühlkörperoberfläche mit einer Kupferstruktur beschichtetes Keramiksubstrat auf. Die Trägerstruktur ist damit eine so genannte DCB-Struktur (DCB = direct bonded copper) mit einer Kupferstruktur zum elektrischen Verbinden, Aufbringen und Entwärmen auf der Trägerstruktur angeordneter elektrischer Bauelemente.

Bei einer weiteren Ausgestaltung der Erfindung weist der Träger auf der Trägerstruktur angeordnete Anschlusskontakte auf, die von der Trägerstruktur abseitig der Kühlkörperoberfläche abstehen. Dies ermöglicht eine Kontaktierung auf der Trägerstruktur angeordneter elektrischer Bauelemente über die Anschlusskontakte, beispielsweise um elektrische Bauelemente anzusteuern. Durch die direkte Positionierung der Anschlusskontakte auf der Trägerstruktur ist keine separate Maschine für eine automatische Pin-Montage mehr notwendig, die hohe Investitionskosten erfordert. Die Platzierung der Anschlusskontakte kann mittels eines in der Regel ohnehin vorhandenen Bestückungsautomaten (so genannter Pick-and-Place Automat) erfolgen. Die direkte Positionierung der Anschlusskontakte auf der Trägerstruktur (und nicht etwa am Rand des Moduls) verkürzt außerdem vorteilhaft die Bonddrahtverbindungen und reduziert damit parasitäre Induktivitäten und Widerstände, was sich vorteilhaft auf die Schaltüberspannung und die elektromagnetische Verträglichkeit der Schaltungsanordnung auswirkt.

Bei einer Weitergestaltung der vorgenannten Ausgestaltung der Erfindung weist der Träger einen Deckel auf, der mit dem Kühlkörper lösbar verbindbar ist, beispielsweise durch wenigstens eine Rastverbindung und/oder wenigstens eine Schraubverbindung, und Deckelöffnungen für die Anschlusskontakte aufweist, um die Anschlusskontakte zu stabilisieren. Der Deckel dient lediglich zum Stabilisieren der Anschlusskontakte gegen ein seitliches Abknicken und hält die Anschlusskontakte somit in ihrer Position. Insbesondere hat der Deckel keine Abdichtfunktion und ist somit ein einfach herstellbares und montierbares Bauteil.

Bei dem erfindungsgemäßen Verfahren zum Herstellen eines erfindungsgemäßen Trägers wird der Kühlkörper durch Stranggießen oder durch Stranggießen mit anschließendem additiven Aufbringen einer die Kühlkörperoberfläche bildenden Wärmespreizschicht hergestellt, die Abdichtblöcke werden durch Spritzgießen hergestellt, und die Trägerstruktur wird durch Löten oder Sintern auf die Kühlkörperoberfläche aufgebracht. Das erfindungsgemäße Verfahren ermöglicht vorteilhaft eine einfache und kostengünstige Herstellung eines erfindungsgemäßen Trägers.

Ein erfindungsgemäßes Elektronikmodul umfasst einen erfindungsgemäßen Träger, wenigstens ein auf der Trägerstruktur des Trägers angeordnetes elektrisches Bauelement und eine Vergussmasse, beispielsweise eine silikonbasierte Weichvergussmasse, die die Trägerstruktur und das wenigstens eine elektrische Bauelement bedeckt. Beispielsweise kann wenigstens ein elektrisches Bauelement ein Leistungshalbleiter-Bauelement, insbesondere ein IGBT oder MOSFET, sein. Da ein erfindungsgemäßes Elektronikmodul einen erfindungsgemäßen Träger für die elektrischen Bauelemente des Elektronikmoduls aufweist, entsprechen die Vorteile eines erfindungsgemäßen Elektronikmoduls den oben genannten Vorteilen eines erfindungsgemäßen Trägers.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
FIG 1 eine perspektivische Darstellung eines ersten Ausführungsbeispiels eines Elektronikmoduls ohne Deckel,
FIG 2 eine perspektivische Darstellung des in FIG 1 gezeigten Elektronikmoduls mit Deckel,
FIG 3 eine Schnittdarstellung des Kühlkörpers des in FIG 1 gezeigten Elektronikmoduls,
FIG 4 eine perspektivische Schnittdarstellung zweier Elektronikmodule gemäß einem zweiten Ausführungsbeispiel.

Einander entsprechende Teile sind in den Figuren mit denselben Bezugszeichen versehen.

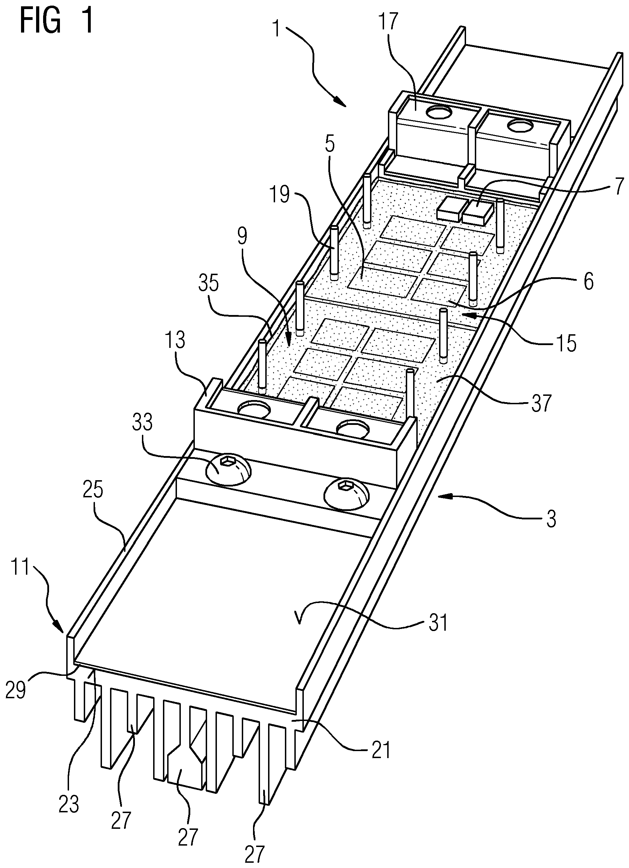

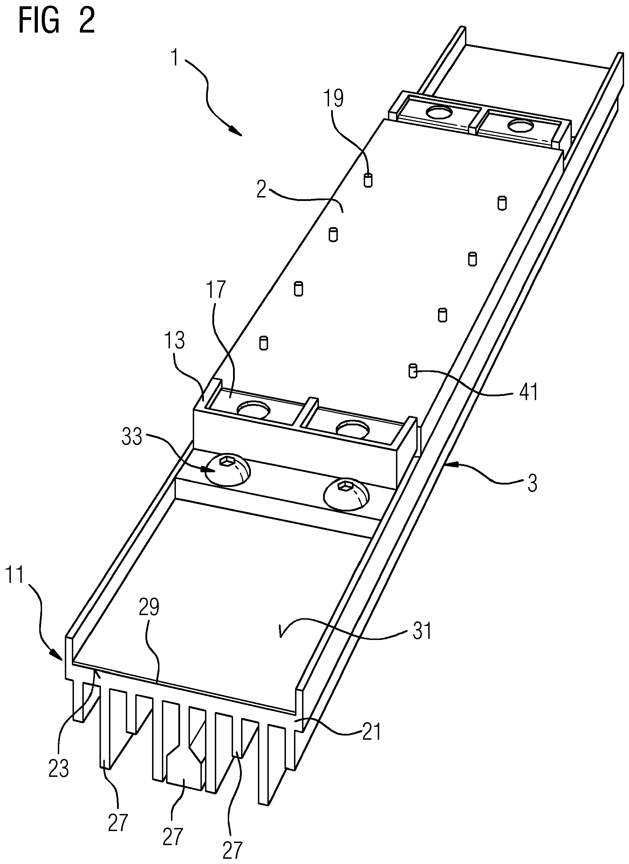

Die Figuren 1 und 2 (FIG 1 und FIG 2) zeigen jeweils eine perspektivische Darstellung eines ersten Ausführungsbeispiels eines erfindungsgemäßen Elektronikmoduls 1. Dabei zeigt Figur 1 das Elektronikmodul 1 ohne Deckel 2 und Figur 2 zeigt das Elektronikmodul 1 mit Deckel 2. Das Elektronikmodul 1 umfasst einen erfindungsgemäßen Träger 3, elektrische Bauelemente 5 bis 7 und eine Vergussmasse 9.

Der Träger 3 umfasst den Deckel 2, einen Kühlkörper 11, zwei Abdichtblöcke 13, eine Trägerstruktur 15, Anschlusslaschen 17 und pinförmige Anschlusskontakte 19.

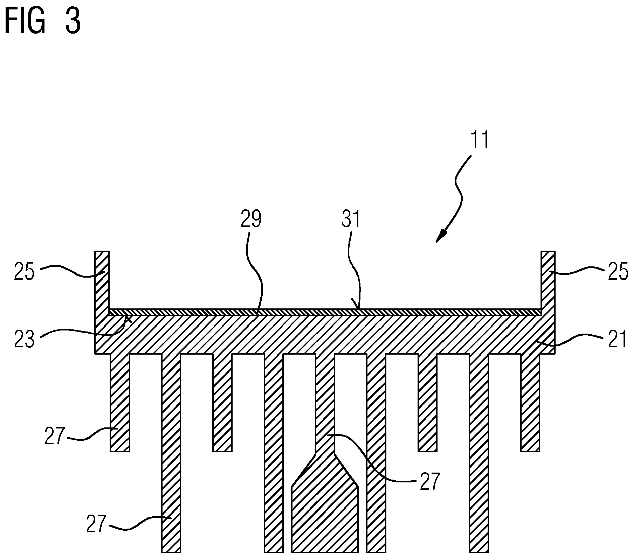

Figur 3 (FIG 3) zeigt eine Schnittdarstellung des Kühlkörpers 11. Der Kühlkörper 11 weist einen Grundkörper 21 auf, der oberseitig eine plane Grundkörperoberfläche 23 und zwei von der Grundkörperoberfläche 23 abstehende, sich gegenüberliegende Seitenwände 25 und unterseitig mehrere Kühlrippen 27 aufweist. Die Grundkörperoberfläche 23 ist mit einer Wärmespreizschicht 29 beschichtet, die eine plane Kühlkörperoberfläche 31 ausbildet. Beispielsweise ist der Grundkörper 21 aus Aluminium durch Stranggießen hergestellt. Die Wärmespreizschicht 29 ist beispielsweise eine Kupferschicht, die beispielsweise gemeinsam mit dem Grundkörper 21 durch Stranggießen hergestellt wird oder additiv, beispielsweise durch Kaltgasspritzen, auf die Grundkörperoberfläche 23 aufgebracht wird. In dem gezeigten Ausführungsbeispiel stehen die Seitenwände 25 senkrecht von der Grundkörperoberfläche 23 ab. In anderen Ausführungsbeispielen können die Seitenwände 25 schräg von der Grundkörperoberfläche 23 abstehen und/oder die Seitenwände 25 können mit der Grundkörperoberfläche 23 in den Übergangsbereichen zwischen den Seitenwänden 25 und der Grundkörperoberfläche 23 ein abgerundetes Profil bilden.

Die beiden Abdichtblöcke 13 sind voneinander beabstandet auf der Kühlkörperoberfläche 31 angeordnet, erstrecken sich jeweils zwischen den beiden Seitenwänden 25 und liegen an jeder der beiden Seitenwände 25 und an der Kühlkörperoberfläche 31 abdichtend an. Jeder Abdichtblock 13 ist durch zwei Schraubverbindungen 33 mit dem Kühlkörper 11 kraftschlüssig verbunden. Zusätzlich kann jeder Abdichtblock 13 durch wenigstens eine (nicht dargestellte) Nut-Feder-Verbindung mit dem Kühlkörper 11 formschlüssig verbunden sein. Beispielsweise werden die Abdichtblöcke 13 durch Spritzgießen aus Kunststoff gefertigt.

Die Trägerstruktur 15 ist auf der Kühlkörperoberfläche 31 zwischen den beiden Abdichtblöcken 13 angeordnet. Die Trägerstruktur 15 weist ein auf der Kühlkörperoberfläche 31 aufliegendes Keramiksubstrat 35 auf, dessen von der Kühlkörperoberfläche 31 abgewandte Seite mit einer Kupferstruktur 37 beschichtet ist, die Leiterbahnen und Kontaktflächen zum elektrischen Verbinden, Aufbringen und Entwärmen der elektrischen Bauelemente 5 bis 7 und der Anschlusskontakte 19 bildet. Die Trägerstruktur 15 ist eine so genannte DCB-Struktur mit dem Keramiksubstrat 35 als DCB-Substrat. Die Trägerstruktur 15 wird durch Löten oder Sintern auf die Kühlkörperoberfläche 31 aufgebracht.

Die Anschlusslaschen 17 bilden Leistungsanschlüsse des Elektronikmoduls 1 zur Versorgung der elektrischen Bauelemente 5 bis 7 mit Gleichstrom und/oder Wechselstrom. Jede Anschlusslasche 17 ist an einem Abdichtblock 13 angeordnet und stufenartig ausgebildet. In alternativen Ausführungsbeispielen können die Anschlusslaschen 17 auch entfallen und die Leistungsanschlüsse von pinförmigen Anschlusskontakten 19 gebildet werden, insbesondere wenn über die Leistungsanschlüsse relativ geringe Ströme (beispielsweise mit Stromstärken unterhalb von 100 A) fließen.

Die Anschlusskontakte 19 umfassen beispielsweise Steueranschlüsse zum Ansteuern elektrischer Bauelemente 5 bis 7. Die Anschlusskontakte 19 sind auf einer von der Kühlkörperoberfläche 31 abgewandten Seite der Trägerstruktur 15 angeordnet und werden beispielsweise durch Ultraschallschweißen oder Löten mit der Kupferstruktur 37 der Trägerstruktur 15 verbunden. In anderen Ausführungsbeispielen können anstelle pinförmiger Anschlusskontakte 19 planar ausgeführte Anschlusskontakte 19 vorgesehen sein.

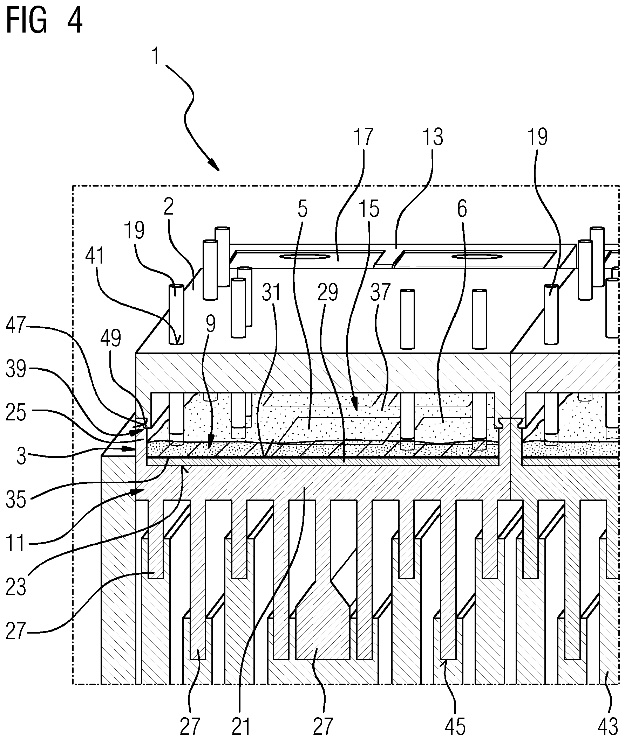

Der Deckel 2 ist mit dem Kühlkörper 11 lösbar verbunden, beispielsweise über Rastverbindungen 39 (siehe Figur 4) und/oder über Schraubverbindungen. Der Deckel 2 weist Deckelöffnungen 41 für die Anschlusskontakte 19 auf. Jeder Anschlusskontakt 19 wird durch eine Deckelöffnung 41 geführt, die den Anschlusskontakt 19 stabilisiert, indem sie ein seitliches Abknicken des Anschlusskontakts 19 verhindert und den Anschlusskontakt 19 somit in seiner Position hält. Der Deckel 2 ist eine optionale Komponente des Trägers 3 und dient lediglich der Stabilisierung der Anschlusskontakte 19. Insbesondere bei Ausführungsbeispielen mit planaren statt pinförmigen Anschlusskontakten 19 kann der Deckel 2 daher entfallen.

Die elektrischen Bauelemente 5 bis 7 sind auf der Trägerstruktur 15 angeordnet. Elektrische Bauelemente 5 bis 7 können beispielsweise Leistungshalbleiter-Bauelemente wie ein IGBT oder MOSFET sein.

Die Vergussmasse 9 ist beispielsweise eine silikonbasierte Weichvergussmasse und bedeckt die elektrischen Bauelemente 5 bis 7 und die Trägerstruktur 15. Die Seitenwände 25 und die Abdichtblöcke 13 verhindern das Ausfließen flüssiger Vergussmasse 9 nach dem Aufbringen auf die elektrischen Bauelemente 5 bis 7 und die Trägerstruktur 15 vor dem Aushärten der Vergussmasse 9.

Figur 4 (FIG 4) zeigt eine perspektivische Schnittdarstellung zweier Elektronikmodule 1 gemäß einem zweiten Ausführungsbeispiel. Die Elektronikmodule 1 sind nebeneinander über einem Kühlbalken 43 angeordnet, der Ausnehmungen 45 für die Kühlrippen 27 der Kühlkörper 11 der Elektronikmodule 1 aufweist. Die Elektronikmodule 1 unterscheiden sich von dem in den Figuren 1 und 2 gezeigten Elektronikmodul 1 lediglich durch die Anordnung elektrischer Bauelemente 5 bis 7 und Anschlusskontakte 19 sowie die Ausbildung der Kupferstruktur 37. Figur 4 zeigt die Ausführung von Rastverbindungen 39 zum Verbinden des Deckels 2 mit dem Kühlkörper 11 eines Elektronikmoduls 1. Jede Rastverbindung 39 wird durch eine Rastnut 47 in einer Seitenwand 25 und eine in die Rastnut 47 eingreifende Rastfeder 49 des Deckels 2 gebildet.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Träger (3) für wenigstens ein elektrisches Bauelement (5 bis 7), der Träger (3) umfassend
- einen Kühlkörper (11) mit einer Kühlkörperoberfläche (31) und zwei von der Kühlkörperoberfläche (31) abstehenden, sich gegenüberliegenden Seitenwänden (25),
- zwei auf der Kühlkörperoberfläche (31) aufliegende, voneinander beabstandete Abdichtblöcke (13), die sich jeweils zwischen den beiden Seitenwänden (25) erstrecken und an jeder der beiden Seitenwände (25) anliegen, und
- eine auf der Kühlkörperoberfläche (31) zwischen den beiden Abdichtblöcken (13) angeordnete Trägerstruktur (15) für das wenigstens eine elektrische Bauelement (5 bis 7).

2. Träger (3) nach Anspruch 1, wobei der Kühlkörper (11) einen Grundkörper (21) und eine die Kühlkörperoberfläche (31) ausbildende Wärmespreizschicht (29), beispielsweise eine Kupferschicht, aufweist.

3. Träger (3) nach Anspruch 2, wobei der Grundkörper (21) aus Aluminium gefertigt ist.

4. Träger (3) nach einem der vorhergehenden Ansprüche, wobei jeder Abdichtblock (13) durch wenigstens eine Schraubverbindung (33) mit dem Kühlkörper (11) kraftschlüssig verbindbar ist.

5. Träger (3) nach einem der vorhergehenden Ansprüche, wobei jeder Abdichtblock (13) mit dem Kühlkörper (11) durch wenigstens eine Nut-Feder-Verbindung formschlüssig verbunden ist.

6. Träger (3) nach einem der vorhergehenden Ansprüche, wobei an wenigstens einem Abdichtblock (13) wenigstens eine elektrisch leitfähige Anschlusslasche (17) für einen elektrischen Leistungsanschluss angeordnet ist.

7. Träger (3) nach einem der vorhergehenden Ansprüche, wobei die Abdichtblöcke (13) aus Kunststoff gefertigt sind.

8. Träger (3) nach einem der vorhergehenden Ansprüche, wobei die Trägerstruktur (15) ein abseitig der Kühlkörperoberfläche (31) mit einer Kupferstruktur (37) beschichtetes Keramiksubstrat (35) aufweist.

9. Träger (3) nach einem der vorhergehenden Ansprüche mit auf der Trägerstruktur (15) angeordneten Anschlusskontakten (19), die von der Trägerstruktur (15) abseitig der Kühlkörperoberfläche (31) abstehen.

10. Träger (3) nach Anspruch 9 mit einem Deckel (2), der mit dem Kühlkörper (11) lösbar verbindbar ist und Deckelöffnungen (41) für die Anschlusskontakte (19) aufweist, um die Anschlusskontakte (19) zu stabilisieren.

11. Träger (3) nach Anspruch 10, wobei der Deckel (2) über wenigstens eine Rastverbindung (39) und/oder wenigstens eine Schraubverbindung mit dem Kühlkörper (11) verbindbar ist.

12. Verfahren zum Herstellen eines Trägers (3) nach einem der vorhergehenden Ansprüche, wobei
- der Kühlkörper (11) durch Stranggießen oder durch Stranggießen mit anschließendem additiven Aufbringen einer die Kühlkörperoberfläche (31) bildenden Wärmespreizschicht (29) hergestellt wird,
- die Abdichtblöcke (13) durch Spritzgießen hergestellt werden und
- die Trägerstruktur (15) durch Löten oder Sintern auf die Kühlkörperoberfläche (31) aufgebracht wird.

13. Elektronikmodul (1), umfassend
- einen Träger (3) nach einem der Ansprüche 1 bis 11,
- wenigstens ein auf der Trägerstruktur (15) des Trägers (3) angeordnetes elektrisches Bauelement (5 bis 7) und
- eine Vergussmasse (9), beispielsweise eine silikonbasierte Weichvergussmasse, die die Trägerstruktur (15) und das wenigstens eine elektrische Bauelement (5 bis 7) bedeckt.

14. Elektronikmodul (1) nach Anspruch 13, wobei wenigstens ein elektrisches Bauelement (5 bis 7) ein Leistungshalbleiter-Bauelement, insbesondere ein Bipolartransistor mit isolierter Gate-Elektrode, ist.
